# EUROPEAN PATENT SPECIFICATION

(11) **EP 0 588 574 B1**
(45) Date of publication and mention of the grant of the patent: **11.11.1998**
(21) Application number: 93307172.2
(22) Date of filing: 10.09.1993
(51) Int. Cl.: H05K 9/00

(54) **Electro-magnetic wave shielding structure**
Abschirmungsstruktur gegen elektromagnetische Wellen
Structure de blindage contre les ondes électromagnétiques

(30) Priority: 11.09.1992 JP 243654/92
(43) Date of publication of application: 23.03.1994
(73) Proprietor: UNIDEN CORPORATION, Ichikawa-shi Chiba-ken (JP); NIPPON PAINT COMPANY LIMITED, Osaka City, Osaka (JP)
(72) Inventor: Konishi, Yoshihiro, Sagamihara City, Kanagawa Pref. (JP); Iida, Shoichi, c/o Nippon Paint Co., Ltd., Neyagawa City, Osaka (JP); Oda, Mitsuyuki, c/o Nippon Paint Co., Ltd., Neyagawa City, Osaka (JP); Nakamura, Koji, c/o Nippon Paint Co., Ltd., Neyagawa City, Osaka (JP)
(74) Representative: Whalley, Kevin

(56) References cited:
- EP-A- 0 398 672
- DE-A- 2 855 134
- US-A- 4 116 906

## Description

The present invention relates to a process for preventing leakage of electro-magnetic waves having a frequency region of one order of 1 GHz generated in an electric apparatus. By means of the invention an electro-magnetic wave shielding structure for preventing undesired leakage of an electro-magnetic wave, particularly, for preventing an electric wave obstruction in surrounding environment, which is caused by undesired leakage of an electro-magnetic wave generated in electric apparatus including an communication apparatus, for instance, a car telephone, a portable telephone and the like.

Recently, cases of electric apparatus of various kinds have a tendency to be formed of plastics which are superior in light weight and plasticity.

On the other hand, inner circuits and electric parts, which are comprised in electric apparatus, include articles which generate undesired electro-magnetic waves causing electric wave obstructions. Particularly, communication apparatus, information apparatus, electronic apparatus comprising integration circuits and the like include many articles which deal with high frequency electric signals together with intense possibility for causing the leakage of high frequency electric waves originating electric wave obstructions.

Accordingly, when the aforesaid case of electric apparatus is formed of plastics having a general property such that an electro-magnetic wave passes therethrough, the aforesaid undesired leakage of the electro-magnetic wave is extremely increased and hence the occurrence of electric wave obstruction becomes a very severe trouble.

Indeed, when special plastics provided for shielding the electro-magnetic wave by containing metal powders or the like therein is employed as for the plastics forming the aforesaid case, the leakage of electro-magnetic wave can be prevented at a certain extent.

However, thus special plastics is expensive at material cost and further the performances thereof including the plasticity are lowered, so that the advantage of the case made of plastics cannot be sufficiently obtained.

Therefore, a measure such as a conductive layer formed by metal plating or conductive material painting is applied on the plastics case has been conventionally proposed. Thus applied conductive layer has a property such as the electro-magnetic wave is reflected thereby, so that the electro-magnetic wave generated in the case can be prevented from the undesired leakage from the case made of plastics according to the reflection attained by the conductive layer thus applied thereon.

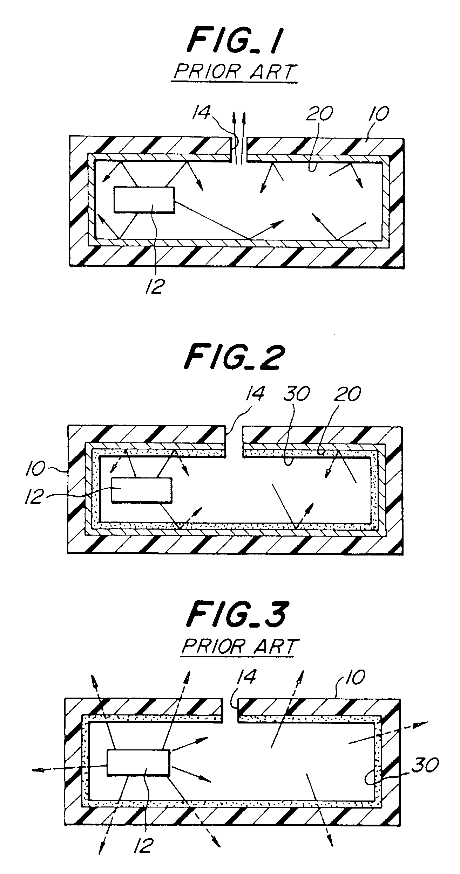

Fig. 1 shows an outline of an electric apparatus comprising thus conventionally proposed electro-magnetic wave shielding structure. In Fig. 1, an electro-magnetic wave reflecting layer 20, which is formed of a metal-plating layer and the like, is applied on an inner face of a case 10 made of plastics, so that an electro-magnetic wave generated in an electro-magnetic wave generating source 12 are reflected at inner faces of the reflecting layer 20 as indicated by arrow marks, so as to be prevented from the passing through the case 10 and the external leakage.

However, even if the electro-magnetic reflecting layer is formed on the inner face of the plastic made case as described above, the leakage of the electro-magnetic wave is conventionally apt to be caused, so that the improvement of this leakage preventing measure has been demanded.

Further speaking in detail, in the case formed of plastics, the leakage of electro-magnetic wave is not caused at portions on which the reflecting layers are applied. However, the case of the electric apparatus is provided with a ventilating hole, an internal inspection hole and the others, so that the electro-magnetic wave leaks through these holes. The electro-magnetic wave in a frequency region in an order of 1 GHz, which has a large possibility of generation inside the electric apparatus and further a large effect of electric wave obstruction, can be readily leaked even from a minute opening and a minute gap which exist in the case, so that it has been difficult to cut the leakage of the electro-magnetic wave in high frequency region.

Moreover, when the electro-magnetic wave reflecting layer has been applied on the inner face of the case made of plastics, the electro-magnetic wave generated in the case concerned is moved entirely within the case by being repeatedly reflected on the reflecting layer with the last result that it is concentrically leaked through the openings. Furthermore, the conductive electro-magnetic wave reflecting layer is operated as if it were a half wavelength antenna, so that it is resulted that the electro-magnetic wave emitted from the local oscillator inside the case is secondarily emitted therefrom. Consequently, the provision of the electro-magnetic wave reflecting layer cannot have been useful as an effective electro-magnetic wave shielding measure.

In other words, as is shown in Fig. 1, when an opening 14 exists in a portion of the case 10, the electro-magnetic wave being repeatedly reflected by the electro-magnetic wave reflecting layer 20 inside the case 10 reaches to the portion on which the opening 14 exists, and hence readily passes through the opening 14 to the outside thereof. The electro-magnetic wave is hardly attenuated so long as it is reflected by the reflecting layer 20, so that the major part of the electro-magnetic wave energy generated from an electro-magnetic wave generating source 12 is possibly leaked through the opening 14 to the outside thereof at the last.

Attention is also drawn to one disclosures of EP-A-0 398 672 and US-A-4 116 986.

An object of the present invention is to dispose of the task of the electro-magnetic wave shielding structure as conventionally proposed as mentioned above by providing a process for obtaining an electro-magnetic wave shielding structure which can effectively prevent the leakage of electro-magnetic waves, even if the opening exists on the case of the electric apparatus.

The present invention provides a process as defined in claim 1.

Accordingly, a electro-magnetic wave shielding structure can be obtained wherein a case and substrates are formed of planar bodies at least each one face of which is made conductive and the conductive faces of said planar bodies are applied with thin films containing ferrite particles which present magnetic loss, so as to prevent undesired leakage of electro-magnetic waves generated in electronic circuits provided on said substrates accommodated in said case through electro-magnetic openings provided on said case.

Consequently, in such an electro-magnetic wave shielding structure, even if openings as for leaking electro-magnetic waves exist on a case accommodating electronic circuits providing electro-magnetic wave generating sources, it is possible to mitigate the occurrence of electric wave obstruction by readily preventing the undesired leakage of electro-magnetic waves.

For the better understanding of the invention, reference is made to the accompanying drawings, in which:
Fig. 1 is a cross-sectional view schematically showing an example of a conventional electro-magnetic wave shielding structure;
Fig. 2 is a cross-sectional view showing an outlined arrangement of an electro-magnetic wave shielding structure obtained by means of the process according to the present invention;
Fig. 3 is a cross-sectional view schematically showing another example of the conventional electro-magnetic wave shielding structure;
Fig. 4 is a graph showing a frequency characteristics of permeability in a first embodiment of the present invention;
Fig. 5 is a graph showing the frequency characteristics of permeability in a second embodiment given for explanatory reasons; and
Fig. 6 is a graph showing a frequency characteristics of permeability in a third embodiment given for explanatory reasons.

Throughout different views of the drawings, 10 is a case, 12 is an electro-magnetic wave generating source, 14 is an opening, 20 is an electro-magnetic wave reflecting layer (a conductive layer), and 30 is an electro-magnetic wave absorbing layer (a magnetically losing layer).

Preferred embodiments of the present invention will be described in detail by referring to accompanying drawings hereinafter.

An electro-magnetic wave shielding structure has a shielding arrangement for preventing leakage of an electro-magnetic wave generated in a case of an electric apparatus. In a first embodiment thereof, conductive films are formed on inner faces of the case made of an electro-magnetic wave passing-through material, on surfaces of which conductive films magnetically losing layers of a thickness exceeding 80 µm which contain Mn-Mg-Zn group soft ferrite particles having a diameter of 1 to 2 µm by 70 to 80 weight % are formed.

As for the electric apparatus to be applied with the present invention, so long as those are electric apparatus comprising electronic circuits which have the possibility for generating electro-magnetic waves, for instance, aforesaid communication apparatus including portable telephones, information apparatus and the like, electric apparatus in any technical field and for any use can be widely included.

In general, the case of the electric apparatus is formed of an electro-magnetic wave passing-through material, for instance, plastics, for which any usual molding resin can be used, and further woody materials and inorganic materials other than plastics, which are used in general for the case construction of apparatus of various kinds, can be employed also. As for the shape and the construction of the case, any shape and any construction which are adapted for the whole construction, can be adopted.

In this connection, it is generally required for the faculty of the electric apparatus that openings including a slit, a hole, a recess and the like exist at least on a part of the case.

As for the conductive layer formed on the inner faces of the case, usual electro-magnetic wave reflecting materials which have been used for the electro-magnetic shielding structure as conventionally proposed also are employed, while, as the method for forming the conductive layer on inner faces of the case, usual methods can be employed. In concrete practice, it can be employed various methods such that plating is performed with good conductive metals, for instance, copper, aluminum or the like, thin films of those metals being formed by deposition or the like, foils of those metals being stuck, various kinds of conductive paints obtained by mixing metal powders into paints being spread, or, films formed of conductive resin being put on with adhesive or cohesive.

In this regard, the thickness of these conductive layers is enough to present the reflectivity such as the electro-magnetic wave passing though the magnetically losing layer formed on the inner face of the case as mentioned later is prevented from the passing-through towards the case. In concrete practice, although being different in response to the kinds and the amount of the electro-magnetic wave generated in the case and further the combination with electro-magnetic absorbing layers, the conductive layers applied on the usual condition are provided with the thickness of 40 to 60 µm.

On the other hand, the magnetically losing layer formed on the surface of the conductive layer is provided with a property such that the loss term of the permeability thereof presents the substantially maximum value at the frequency of the undesired leakage electro-magnetic wave, and, further concretely speaking, that the electric current path from the electro-magnetic wave generating portion of the electronic circuit to the openings thereof is largely varied through the resistance based on the loss term. So that, the larger the magnetic loss term is, the more effectively the emission from the conductive layer is suppressed.

In this connection, as for this magnetic loss term, an article which does not entirely reflect the electro-magnetic wave is desired. However, for the practical use, a material having a property such as the low reflectivity of the electro-magnetic wave and the high magnetic loss in comparison with the aforesaid conductive layer is preferably used for forming it.

In the first embodiment of the present invention, as for the magnetically losing layer presenting the aforesaid property, the magnetically losing layer of the thickness exceeding 80 µm which contains Mn-Mg-Zn group soft ferrite particles having a diameter of 1 to 2 µm by 70 to 80 weight % is employed. This Mn-Mg-Zn group soft ferrite particle consists of the so-called soft ferrite formed by the combination of Fe₂O₃ with ZnO, MgO, MnO and others, while the crystal structure thereof is of spinel type. In this connection, as for this soft ferrite particle, an article of a diameter 1 to 2 µm is used.

For forming a thin film of aforesaid soft ferrite particles on the surface of the conductive layer applied inside the case, it is enough to apply an article made by mixing or kneading these particles with a binder of resin or the like.

In this regard, it can be adopted also that a film of resin containing soft ferrite particles is previously prepared and then this magnetically losing film is put on.

In this connection, the larger the percentage of soft ferrite particles to be occupied in this magnetically losing layer is, the better the performance of electro-magnetic wave attenuation becomes. However, for facilitating the formation of this layer through spreading or the like, it is required to contain resin and others at a certain large percentage. So that, it is preferable from this point of view that soft ferrite particles are contained by 70 to 85 weight %.

On the other hand, as for the resin to be mixed with soft ferrite particles for forming the electro-magnetic wave absorbing layer, any kind of resin can be adopted so long as the formation of the layer through the spreading and the like can be preferably attained.

For instance, painting resins including acryl, epoxy, urethane, alkyd and others, or, film-forming resins including vinyl chloride and others can be adopted. Meanwhile, the thicker the magnetically losing layer is, the better the faculty of electro-magnetic wave attenuation becomes.

In the first embodiment of the present invention, for sufficiently manifesting the faculty of electro-magnetic wave attenuation, the thickness of the magnetically losing layer is arranged to be at least 80 µm, preferably at least 100 µm. In this connection, the more the thickness of the electro-magnetic wave absorbing layer is increased, the more the time and the cost which are required for forming the layer, for instance, by spreading. So that, an appropriate thickness of this layer should be selected through these various conditions.

As is described above, according to the present invention, when two kinds of layers, that is, the conductive layer and the magnetically losing layer are doubly formed inside the case consisting of the electro-magnetic wave passing-through material, firstly, the leakage of electro-magnetic wave through the portion covered with the conductive layer is prevented by the electro-magnetic wave reflecting action thereof, and further, secondarily, the undesired leaking electro-magnetic wave emitted from the conductive layer acting as an emitter through minute openings and slits which exist on the case is largely attenuated through the resistance based on the magnetically losing layer doubly disposed on the conductive layer.

As a result obtained from the described above, in the electro-magnetic wave shielding structure obtained by the process according to the present invention, even if the case formed of electro-magnetic passing-through material, for instance, plastics is employed and further openings exist on a part thereof, any electro-magnetic wave does not leak out of the case, so that extremely preferable operation of electro-magnetic wave shielding can be attained.

An outlined arrangement of an electro-magnetic wave shielding structure obtained by the process according to the present invention is schematically shown in Fig. 2. In this outlined structure, an electro-magnetic wave generating source 12, for instance, a high frequency circuit is provided in a case 10 formed of an electro-magnetic passing-through material, for instance, plastics. From this generating source 12, electro-magnetic waves are emitted towards the surroundings as indicated by arrow marks. An opening 14 is provided on a part of the case 10, whilst a conductive layer 20 and a magnetically losing layer 30 are subsequently formed inside the case 10.

In the above outlined arrangement, the electro-magnetic wave emitted from the source 12 is absorbed by the magnetically losing layer 30 and hence is attenuated, while the electro-magnetic wave passing through the magnetically losing layer 30 is reflected by the conductive layer 20 and hence cannot reach to the case 10 proper existing outside the conductive layer 20. Consequently, the electro-magnetic wave leaking through the opening 14 becomes extremely scarce.

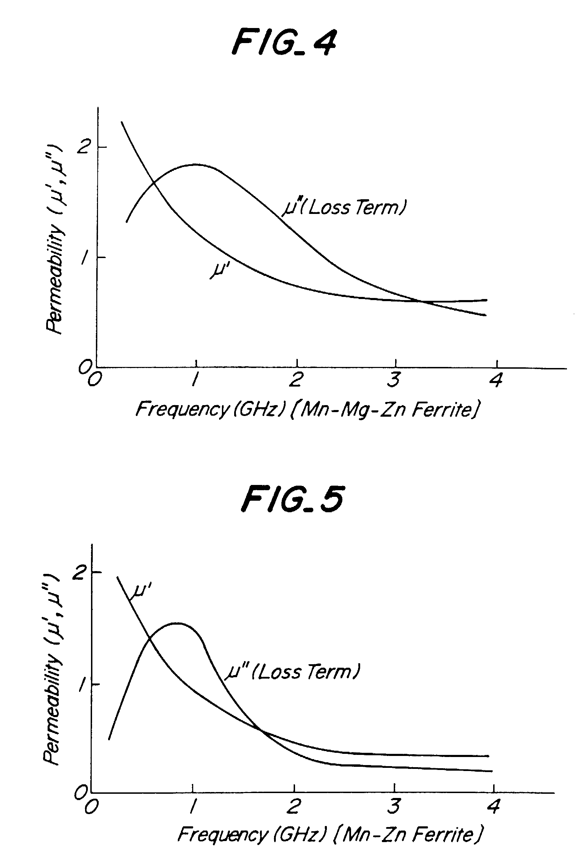

It is a necessary condition for the present invention that both of the conductive layer 20 and the magnetically losing layer 30 are formed on the inner face of the case 10, as is apparent from Fig. 2 in comparison with Fig. 3 showing another conventional arrangement. In the arrangement provided with the magnetically losing layer 30 only inside the case 10 as shown in Fig. 3, a major part of the electro-magnetic wave saved from the absorption through the magnetically losing layer 30 reaches the case 10 proper, and then readily leaks outside through the case 10 proper, which is conventionally formed of the electro-magnetic wave passing-through material.

The magnetically losing layer 30 cannot perfectly absorb the electro-magnetic wave in practice, so that a part of the electro-magnetic wave cannot help passing through the magnetically losing layer 30. Accordingly, it is extremely effective that, according to the present invention, the conductive layer 20 is provided outside the magnetically losing layer 30, so as to reflect the electro-magnetic wave passing through the magnetically losing layer 30 by the conductive layer 20 for preventing the reach thereof to the case 10.

Next, a further embodiment of the present invention will be described hereinafter. As an preferable example of the electric apparatus to be applied with the present invention, a portable telephone accommodated in a case, which is formed of Pc/ABS polymer alloy resin and provided with openings for a mouthpiece and a phone, is adopted. As for the conductive layer, a conductive paint belonging to Cu-Ag/acryl resin group is spread inside the case with a thickness 50 to 70 µm.

In the aforesaid first embodiment, as for the magnetically losing layer, a spread film consisting of Mn-Mg-Zn group soft ferrite particles and resin is formed on the conductive layer. The Mn-Mg-Zn group soft ferrite particle consists of Fe₂O₃ of 45 weight parts, ZnO of 20 weight parts, MgO of 28 weight parts and MnO of 7 weight parts and has a diameter 1 to 2 µm. A paint formed by dispersing soft ferrite particles of 80 weight % and acryl resin group varnish of 20 weight % into a solvent is spread by air-spray and then dried, so as to form the electro-magnetic absorbing layer.

A portable telephone was constructed with use of the case on the inner face of which the conductive layer and the magnetically losing layer was applied. Thereafter, the leakage of an electro-magnetic wave which was generated inside the case during the operation of this telephone was measured as described below with regard to the intensity thereof at the frequency 962 MHz, which frequency was customarily generated in the portable telephone of this kind and frequently caused serious electric wave obstruction.

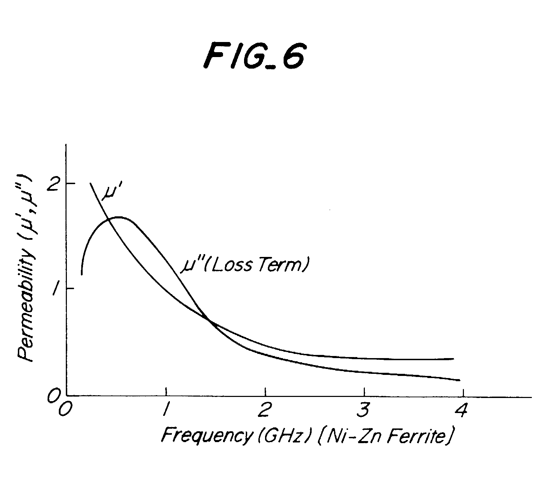

Respective frequency characteristics of permeability in first, second and third embodiments in which kinds of soft ferrite particles differ from each other are shown in Figs. 4, 5 and 6 respectively.

On the other hand, the measured result of the intensity of leaked electro-magnetic wave is shown in Table 1, while similar measured results obtained when the conditions regarding the percentage of soft ferrite particles contained in the magnetically losing layer and the thickness of the conductive layer in the first embodiment are varied are shown in Table 2 and 3 respectively. In Table I, the embodiments 2 and 3 are outside the scope of the invention because they do not use Mn-Mg-Zn group soft ferrites. In this connection, as for the composition of the soft ferrite particle, it is preferable to select an article such as the loss term µ" of the permeability presents substantially the maximum value in the frequency region of the undesired electro-magnetic wave.

**Table 1**

| Difference based on Kinds of Soft Ferrite Particles | | | | |
|---|---|---|---|---|
| | Kind of soft ferrite particle | Layer thickness (µm) | Layer content (weight %) | Electro-magnetic wave intensity (dB) |
| Embodiment 1 | Mn-Mg-Zn group | 100 | 80 | -84 |
| Embodiment 2 | Mn-Zn group | 100 | 80 | -75 |
| Embodiment 3 | Ni-Zn group | 100 | 80 | -78 |
| Reference Example | - | 0 | - | -75 |

In this regard, the reference example as shown in this table indicates that the larger the minus numerical value of the electric wave intensity becomes, the larger the attenuation of electric wave is and hence the lesser the leaked electric wave is.

According to the above measured results, in the first embodiment in which the magnetically losing layer containing Mn-Mg-Zn group soft ferrite particles is formed, the improvement of electro-magnetic wave shielding faculty, which is attained by 9 to 6 dB in comparison with the second and the third embodiments in which the magnetically losing layer containing another soft ferrite particle is formed or the reference example in which the conductive layer only is formed, have been obtained.

**Table 2**

| Difference based on Content of Soft Ferrite Particles | |
|---|---|
| Layer content (weight %) | Electro-magnetic wave intensity (dB) |
| 50 | -76 |
| 60 | -76 |
| 70 | -80 |
| 80 | -84 |
| 85 | -85 |

In this regard, the soft ferrite particle belongs to Mn-Mg-Zn group and the thickness of the layer is 100 µm,

According to the above measured results, when the content of soft ferrite particle is less than 70 weight %, the effect of the further provision of the magnetically losing layer can be scarcely obtained, while the electro-magnetic wave shielding faculty is improved by the increase of the content concerned. Meanwhile, when the content concerned exceeds 85 weight %, the operativity is reduced by the difficult formation of the film, so that the practical usability is frequently reduced.

**Table 3**

| Difference based on Layer Thickness of Absorbing Layer | |
|---|---|
| Layer thickness (µm) | Electro-magnetic wave intensity (dB) |
| 50 | -78 |
| 80 | -82 |
| 100 | -84 |
| 200 | -85 |
| 300 | -86 |

In this regard, the soft ferrite particle belongs to Mn-Mg-Zn group and the content thereof is 80 weight %.

According to the above measured results, it is apparent that, when the thickness of the magnetically losing layer exceeds 80 µm, a sufficient electro-magnetic wave shielding effect can be obtained.

As is apparent from the described above, in the electro-magnetic wave shielding structure obtained by the process according to the present invention, it is possible to remarkably reduce the amount of undesired electro-magnetic wave leaked from the case formed of electro-magnetic wave passing-through material by combining the magnetically losing layer containing soft ferrite particles and the conductive layer. Particularly, in a conventional electro-magnetic wave shielding structure applied with the conductive reflecting layer only, the undesired leakage of electro-magnetic wave has been concentrically caused through the opening portions provided in the case, whereas, in the electro-magnetic wave shielding structure obtained by the process according to the present invention, it is facilitated to securely prevent the undesired leakage of electro-magnetic wave through those opening portions, and further to securely shield the electro-magnetic wave in the frequency region of 1 GHz order which is difficult to be shielded according to the conventional manufacturing technique of the electric apparatus.

Consequently, as for the electric apparatus in which the undesired electro-magnetic wave is frequently generated, for instance, the communication apparatus and the information apparatus which are recently utilized in various technical field, it is facilitated that the electric wave obstruction toward the surrounding environment is steadily prevented and hence the promoted demand and the enlarged use of these electric apparatus are largely contributed thereby.

## Claims

1. A process for preventing leakage of electro-magnetic waves having a frequency region of the order of 1 GHz generated in an electric apparatus comprising a case (10) and an electro-magnetic wave generating source (12) disposed in said case (10), comprising fonning a conductive film (20) as an electro-magnetic wave reflecting layer on an inner surface of said case (10) and then forming a magnetically losing layer (30) as an electro-magnetic wave absorbing layer containing ferrite particles on said conductive film (20), characterized in that said magnetically losing layer (30) has a thickness of 80 to 300 µm and indicates maximum value of loss term (µ") of magnetic permeability in the frequency region of electro-magnetic waves of the order of 1 GHz, and in that said ferrite particles are Mn-Mg-Zn group soft ferrite.

2. A process as claimed in claim 1, characterized in that the said magnetically losing layer (30) contains said ferrite particles in an amount from 70 to 85 weight %, the balance being resin.

3. A process as claimed in claim 1 or 2, characterized in that said ferrite particles have a diameter of 1 to 2 µm.

## Patentansprüche

1. Verfahren zum Verhindern von Leckstrahlung elektromagnetischer Wellen mit einem Frequenzbereich in der Größenordnung von 1 GHz, die in einem Elektrogerät erzeugt werden, das ein Gehäuse (10) und eine in dem Gehäuse (10) angeordnete Quelle zur Erzeugung elektromagnetischer Wellen (12) aufweist, wobei das Verfahren die folgenden Schritte aufweist: Ausbilden einer leitfähigen Folie (20) als Reflexionsschicht für elektromagnetische Wellen an einer Innenfläche des Gehäuses (10) und anschließende Ausbildung einer magnetischen Verlustschicht (30) als Absorptionsschicht für elektromagnetische Wellen, die Ferritteilchen enthält, auf der leitfähigen Folie (20), dadurch gekennzeichnet, daß die magnetische Verlustschicht (30) eine Dicke von 80 bis 300 µm und im Frequenzbereich elektromagnetischer Wellen in der Größenordnung von 1 GHz einen Maximalwert des Verlustterms (µ") der magnetischen Permeabilität aufweist, und daß die Ferritteilchen Weichferrit der Mn-Mg-Zn-Gruppe sind.

2. Verfahren nach Anspruch 1, dadurch gekennzeichnet, daß die magnetische Verlustschicht (30) die Ferritteilchen in einem Anteil von 70-85 Gew.-% enthält, wobei der Rest Harz ist.

3. Verfahren nach Anspruch 1 oder 2, dadurch gekennzeichnet, daß die Ferritteilchen einen Durchmesser von 1 bis 2 µm aufweisen.

## Revendications

1. Procédé permettant d'éviter les fuites d'ondes électromagnétiques couvrant un domaine de fréquence de l'ordre de 1 GHz générées dans un appareil électrique comprenant une enceinte (10) ainsi qu'une source générant une onde électromagnétique (12) disposée dans ladite enceinte (10), procédé comprenant la formation d'un film conducteur (20) sous forme d'une couche réfléchissant l'onde électromagnétique sur la surface interne de ladite enceinte (10) et ensuite la formation d'une couche à perte magnétique (30) sous forme d'une couche absorbant l'onde électromagnétique contenant des particules de ferrite sur ledit film conducteur (20), caractérisé en ce que ladite couche à perte magnétique (30) possède une épaisseur de 80 à 300 µm et indique une valeur maximum du terme de perte (µ") de la perméabilité magnétique dans le domaine de fréquence des ondes électromagnétiques de l'ordre de 1 GHz, et en ce que lesdites particules de ferrite sont des ferrites lisses du groupe Mn-Mg-Zn.

2. Procédé comme celui revendiqué dans la revendication 1, caractérisé en ce que la couche de perte magnétique (30) contient lesdites particules de ferrite dans une quantité comprise entre 70 et 85% en poids, le solde étant de la résine.

3. Procédé comme celui revendiqué dans la revendication 1 ou 2, caractérisé en ce que lesdites particules de ferrite présentent un diamètre compris entre 1 et 2 µm.
